Europäisches Patentamt

European Patent Office

Office européen des brevets

(11) Publication number: **0 154 431**
**B1**

# EUROPEAN PATENT SPECIFICATION

(45) Date of publication of patent specification: **16.08.89**

(51) Int. Cl.⁴: **H 01 L 23/52,** H 01 L 23/14, H 01 L 25/04

(21) Application number: **85301014.8**

(22) Date of filing: **15.02.85**

(60) Consolidated with **85901243.7/0172889** (European application No./publication No.) by decision dated **27.10.88.**

(54) Integrated circuit chip assembly.

(30) Priority: **17.02.84 US 581259**
**17.02.84 US 581336**
**17.02.84 US 581260**
**21.02.84 US 582079**

(43) Date of publication of application:
**11.09.85 Bulletin 85/37**

(45) Publication of the grant of the patent:
**16.08.89 Bulletin 89/33**

(84) Designated Contracting States:
**DE FR GB IT NL**

(56) References cited:
**GB-A-1 457 866**
**GB-A-2 047 466**

**IBM TECHNICAL DISCLOSURE BULLETIN, vol. 15, no. 2, July 1972, New York, USA; D.J. BODENDORF et al. "Active silicon chip carrier", pages 656-657**

**IBM TECHNICAL DISCLOSURE BULLETIN, vol. 19, no. 4, September 1976, New York, USA; S. MAGDO "Pyramid shaped electrical feedthrough in silicon wafers", pages 1232-1233**

(73) Proprietor: **AMERICAN TELEPHONE AND TELEGRAPH COMPANY**
**550 Madison Avenue**
**New York, NY 10022 (US)**

(72) Inventor: **Ng, Kwok Kwok**
**1581 Walker Avenue**
**Union New Jersey 07083 (US)**
Inventor: **Sze, Simon Min**
**132 Burlington Road**
**Murray Hill New Jersey 07974 (US)**
Inventor: **Tai, King Lien**
**344 Park Avenue**
**Berkeley Heights New Jersey 07922 (US)**

(74) Representative: **Buckley, Christopher Simon Thirsk et al**
**AT&T (UK) LTD. AT&T Intellectual Property Division 5 Mornington Road**
**Woodford Green, Essex IG8 OTU (GB)**

Courier Press, Leamington Spa, England.

## Description

Technical field

The invention is concerned with integrated circuit technology.

Background of the invention

To satisfy an ever-increasing demand for computing and data processing power both with respect to processing speed and storage capacity, computer design has been evolving toward increasingly compact arrangements of components and assemblies. Attention has been directed to the number of so-called package levels (a package being defined as a group of structurally similar components or assemblies) as, e.g., by R. F. Bouner et al, "Advanced Printed-Circuit Board Design for High-Performance Computer Applications," *IBM Journal of Research and Development,* Vol. 26, No. 3, May 1982, pp. 297—305.

Attention has also been given to the way components and assemblies are interconnected; e.g., C. W. Ho et al. "The Thin-Film Module as a High-Performance Semiconductor Package," *IBM Journal of Research and Development*, Vol. 26, No. 3, May 1982, pp. 287—296, discuss a multichip module of silicon chips attached to thin-film transmission lines. Among early proposals for the achievement of high device density in silicon technology is one by P. Kraynak et al, "Wafer-Chip Assembly for Large-Scale Integration," *IEEE Transactions on Electron Devices*, Vol. ED-15, No. 9, September 1968, pp. 660—663, where silicon chips are bonded "face down" on a silicon wafer.

Summary of the invention

Integrated circuit chips are assembled on a single-crystal carrier substrate and are electrically interconnected. Silicon is a preferred substrate material.

According to one aspect of this invention a device comprises a substrate and at least one integrated circuit chip attached to said substrate, said substrate consisting essentially of a single-crystal material, and said at least one integrated circuit chip being electrically connected to lithographically defined electrical circuitry on said substrate, wherein said substrate has at least one surface depression which has at least one sloping wall resulting from crystallographically anisotropic etching, said at least one chip has at least one beveled edge resulting from crystallographically anisotropic etching, and said at least one beveled edge and said at least one sloping wall are in juxtaposition and being mutually supplementary, whereby said at least one chip is positioned on said substrate.

In one embodiment of the invention, the positioning of at least one chip on the carrier substrate involves bringing at least one beveled sidewall of said at least one chip in juxtaposition .with a sloping wall of a surface depression such as, e.g., a well, groove or opening in the carrier substrate. Substrate and chip materials are crystallographically .compatible, essentially single-crystal materials, and they are preferably essentially the same. Sloping walls are made by crystallographically anisotropic etching which acts at differing rates in different crystallographic directions, angles other than 90 degrees are thus produced between etched surfaces and surfaces which are not exposed to an etchant. Typically, alignment of chips involves match-up between two or four pairs of sloping faces, e.g., when chips are aligned in grooves or in four-sided wells.

Electrical connection can be effected by contacts on sloping walls; alternatively, connections can be made by one or several conductive paths overlying the chip and the substrate.

According to another aspect of this invention a device comprises a substrate and at least one integrated circuit chip attached to said substrate, said substrate consisting essentially of a single-crystal material, and said at least one circuit chip being electrically connected to lithographically defined electrical circuitry on said substrate, wherein said substrate is a wafer having top and bottom surfaces, the wafer having conductive terminal portions along the periphery thereof overlying said top and bottom surfaces, at least one of said circuit chips is mounted on one of said surfaces of the wafer and includes conductive elements in a central portion of the chip, and a conductive pattern connects the elements of the mounted chip to selected ones of said terminal portions or to elements included on at least one other mounted chip, and wherein (a) whenever said conductive elements are on an unmounted surface of the chip, each chip has at least one sloped edge extending from said central portion of the chip toward the surface of the wafer carrying the mounted chip, said pattern being disposed on sloped edge(s) of each mounted chip and overlying the surface of the wafer, and (b) whenever said conductive elements are on a mounted surface of the chip, said wafer has an opening exposing the central portion of the chip with at least one wall of the opening sloping away from the chip and toward the surface of the wafer opposite to that carrying the chip, said pattern being disposed on said at least one of the sloped walls of the wafer associated with the mounted chip and overlying the said opposite surface of the wafer.

In another embodiment of the invention, an assembly comprises at least one integrated circuit chip, active surface up, on the top side of a wafer. Conductive pads are located in a central portion of the top surface of the mounted chip. The top side of the wafer and all but peripheral portions of the attached chip(s) are then coated with an etch-resistance layer. Subsequently, each chip is etched to form sloped edges between the active area of the device and the top side of the wafer. By utilizing standard conformal integrated-circuit fabrication techniques, conductive patterns are defined and formed on the top side of the wafer and on at least one of the sloped edges to connect the chip pads to pads on other chips or to

conductive terminals disposed along the periphery of the wafer or to both. The wafer-size assembly thus made is further processed (for example, encapsulated) in conventional ways and is then available as a monolithic component exhibiting advantageous performance and cost characteristics. In other embodiments of the invention, at least one chip of the type described is mounted on each side of a wafer. Additionally, connections may be established between chips mounted on the two sides of the wafer. In these ways, a particularly compact and dense wafer-size assembly is realized.

In another embodiment of the invention, an assembly comprises at least one chip which is mounted on the bottom side of a wafer. Conductive pads are located in a central portion of the top surface of the mounted chip. The wafer is then patterned to form a sloped-wall through-aperture in registry with the central portion, and thus with the conductive pads, of each mounted chip. Subsequently, by utilizing standard integrated-circuit fabrication techniques, a conductive pattern is formed overlying the top side of the wafer and on the sloped walls to connect the conductive pads of each chip to other chips or to conductive terminals on the top side of the wafer near the periphery thereof or to both. The wafer-size assembly thus made is further processed (for example, encapsulated) in conventional ways and is then available as a monolithic component for inclusion in an electronic system.

Brief description of the drawing

Fig. 1 is a schematic, cross-sectional view of a portion of a circuit chip;

Fig. 2 is a schematic, cross-sectional view of a portion of a wafer;

Fig. 3 is a reduced-scale, schematic plan view of an integrated circuit assembly illustrating a ground metallization layer and a power metallization layer deposited side by side;

Figs. 4, 5 and 6 are schematic cross-sectional views of an integrated circuit assembly at different stages of manufacture;

Figs. 7 through 14 are schematic representations, not drawn to scale, of portions of a specific illustrative assembly;

Figs. 15 through 24 are schematic representations, not drawn to scale, of portions of a specific illustrative assembly.

Detailed description

The following terms are prominently used in the description of the invention, and their meaning is as follows:

A *substrate* is a material body which has a surface which can serve as a support for material objects which may be insufficiently rigid in the absence of support or whose spatial arrangement depends on the presence of a support. A substrate typically is relatively thin as compared with a planar extent.

A *carrier substrate* and a *chip* are mutually defined as substrates of relatively larger and smaller size, respectively, so that a plurality of chips can be attached to a carrier substrate.

An *integrated* circuit is a miniaturized electrical circuit which is supported by a substrate.

*Preferential etching* or *crystallographically anisotropic etching* is a chemical process which results in removal of surface matter at rates which differ depending on crystallographic direction in an essentially single-crystal material.

In the interest of positioning a chip on a carrier substrate so as to facilitate electrical interconnection of circuitry on the chip and on the substrate, preferential etching is applicable to at least a portion of substrate material and at least a portion of chip material. Such portions are here designated as body portions, and it is understood that substrate and chip may comprise portions other than such body portions such as, e.g., devices, circuits, and passive components.

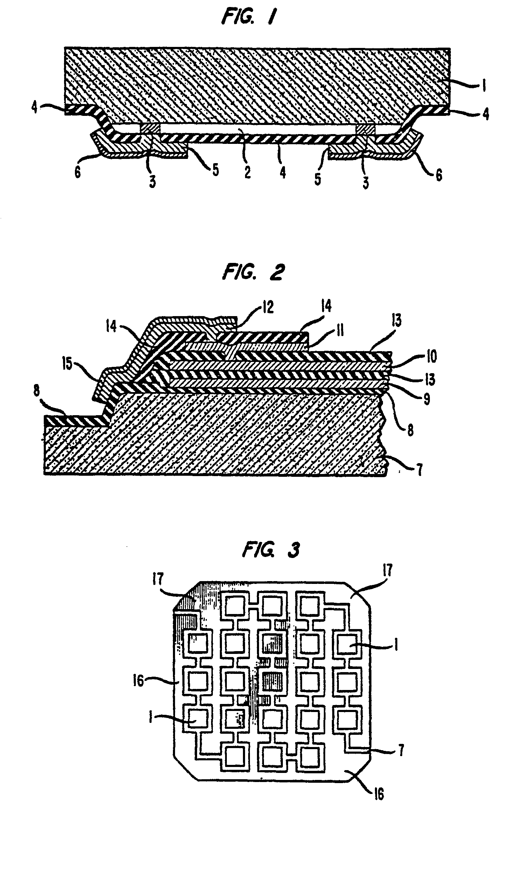

Fig. 1 shows chip 1, integrated circuit 2 with contact pads 3, insulating layer 4, metallic contact 15 which is preferably solder-wettable as, e.g., when consisting essentially of a Ti-Pd-Au or Cr-Cu-Au alloy, and solder metal 6. Beveled portions of chip 1 preferably have a depth which is at least $5.1 \times 10^{-3}$ cm (2 mils).

Fig. 2 shows carrier substrate 7 which serves as electrical ground electrode and which is heavily doped at the surface, insulating oxide layer 8, power supply metallic conductor 9, x-signal metallic conductor 10, y-signal metallic conductor 11, metallic contact stripe 12, polymeric insulating layers 13, cap layer 14 made, e.g., of silicon nitride, and solder metal layer 15. The material of conductors 9, 10 and 11, is typically aluminum, and the material of metallic contact 12 is preferably solder wettable as, e.g., when consisting essentially of a Ti-Pd-Au or Cr-Cu-Au alloy. Metallization 9, oxide layer 8, and substrate 7 form a metal-oxide-semiconductor decoupling capacitor. Electrical contact stripe 12 is shown connected to x-conductor 10; other contact stripes (not shown) may be connected to power supply 9 or y-conductor 13.

Fig. 3 shows wafer 7 serving as carrier substrate for chips 1, ground metallization layer 16, and power metallization layer 17. There is easy access to each chip from ground and power metallizations; more elaborate metallization patterns may be used as needed; e.g., narrow stripes of ground and power metallizations may extend at least partly around a chip to facilitate access to ground or power from any side of a chip.

Ground metallization layer 16 is electrically connected to heavily doped silicon substrate 7, and power layer 17 is deposited on a thin insulating layer, e.g., layer 8 as shown in Fig. 2.

The material of chip 1 and of carrier substrate 7 in Figs. 2 and 3 is preferably the same, essentially single-crystal material which is amenable to preferential etching. Silicon is a primary example of such a material, potassium hydroxide being a convenient etchant in this case. (Etching of silicon for mask alignment is disclosed in U.S. Patent No. 4,470,875.) Among other suitable materials are III—V semiconductor compounds such as, e.g., gallium arsenide and gallium arsenide indium phosphide.

In a preferred embodiment, unpackaged silicon chips are mounted onto a silicon wafer which serves as carrier substrate. Inter-chip connections are provided by two levels of signal nets with 5—15 μm wide conductive paths, power plane and a ground plane. To insulate the planes, a photodefinable polymer (such as, e.g., a photosensitive polyimide) having a low dielectric constant is used.

Methods to interconnect the chips and the wafer include techniques such as, e.g., wire bonding, tape-automatic bonding or "flip-chip" solder balls on solder pads. Moreover, as illustrated by Figs. 1 and 2, self-aligned micro-stripes of solder metal on the chip can be used to connect to similar stripes on the wafer.

In a preferred embodiment of the invention, in the case of silicon wafers and chips, it is possible to fabricate chips with precisely oriented beveled sides ((111) faces) by anisotropic wet etching of wafers having (100) surface planes, with the resulting beveled faces at an angle of 54—55 degrees. These can be inserted into matching beveled wells in silicon wafers, with an angle of 126—125 degrees between the bevel and the wafer plane.

Micro-solder stripes over the beveled oxides of the chips and wells can be defined in a CVD deposited, evaporated or sputtered resist, such as, e.g., $Ag_{2.0}Se/Ge_{0.15}Se_{0.85}$ which allows nonplanar lithography. After the beveled chips have been dropped into the corresponding wells in the wafer, the micro-solder stripes on the chips and on the walls of the wells can be fused by reflowing the solder.

Passive components such as resistors, capacitors and crystal oscillators can be incorporated into the silicon wafer by mounting on similarly beveled silicon plugs which are fitted into wells in the wafer. Furthermore, optical fibers may terminate on a chip which may carry, e.g., an optical detector or a laser.

Beveled silicon planes can also be used for interconnection changes or customizations. Some wells may traverse the entire wafer thickness to allow interconnection, changes, or repairs on a circuit.

When 10.2 cm, or 12.7 cm (4" or 5") silicon wafers are used, one wafer can replace a printing wiring board to form a subsystem or a system. This is advantageous because the high chip packing density allows short average interconnection lengths, short delay times, and lower capacitance and power consumption. Simultaneous switching noise induced by the inductance of the bonding wires is eliminated.

The self-aligned micro-solder stripes technique can provide an input/output of 400—800 I/O channels per chip without penalty in chip packing density. The all-silicon system proposed alleviates the present reliability problems due to thermal mismatch between silicon, ceramics and printed circuit board materials, and the high thermal conductivity of silicon minimizes the danger of overheating of the components.

An example of an application is a "memory pack" consisting of a set of wafers stacked together, each wafer having an array of high density memory chips. Such a pack offers the speed of a random access memory and the mass storage capacity of a disc.

The entire system can be designed by existing computer aided design processes and computer aided testing can be implemented. The drastic increase in I/O capability and chip packing density should provide new opportunities in system architecture. Since the penalty of "going off" the chip is removed, there is a lesser need to increase the number of circuits per chip. Thus, yield would be increased as the chip sizes are reduced. Furthermore, faster circuits with submicron design rules become manufacturable as the chip size shrinks.

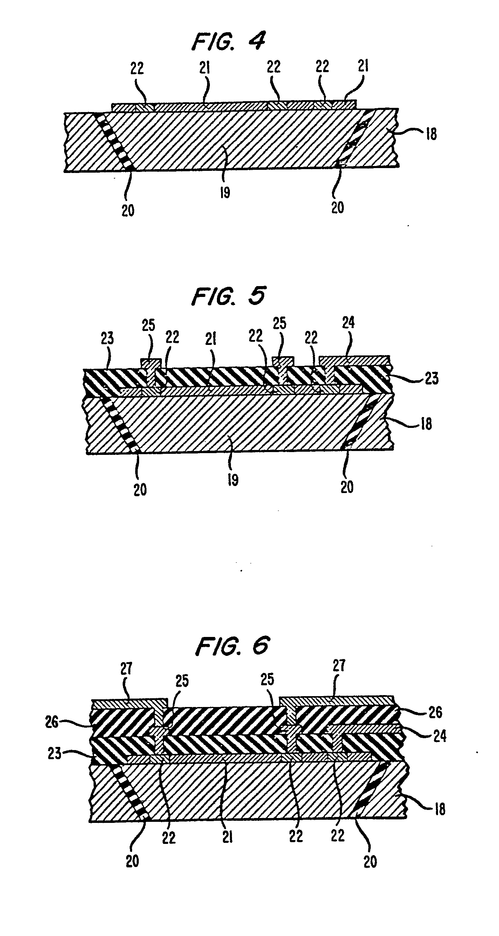

Figs. 4, 5, and 6 show substrate 18, chip 19, insulating filler 20, and integrated circuit 21 with contact pads 22.

Figs. 5 and 6 further show planarized insulating layer 23, electrical conductor 24, and contact pads 25.

Fig. 6 further shows planarized insulating layer 26 and electrical conductors 27.

Substrate 18 and chip 19 in Figs. 4—6 are preferably made of the same, essentially single-crystal material which is amenable to preferential etching, silicon being a primary example of such material.

In particular, in the case of silicon, it is possible to fabricate chips with precisely oriented beveled sides (i.e., (111) faces) by anisotropic wet etching of (100) planes, with the resulting beveled faces at an angle of 54—55 degrees. Matching beveled walls in Si wafers can be made with an angle of 126—125 degrees between the bevel and a wafer plane. In the Figures the angle of 54—55 degrees is between the top surface of chip 19 and the beveled face of the chip, and the angle of 126—125 degrees is between the top surface of wafer 18 and the beveled face of the wafer).

The following sequence of steps can be used to make an assembly embodying the invention: Circuits are produced on chip-size portions of a substrate in customary fashion by deposition of layers and photolithographic patterning. A layer of silicon nitride is deposited on front and back sides of the silicon wafer, a layer of a photoresist material is deposited on the silicon nitride on the back side, and a pattern corresponding to desired chips or openings is optically projected onto the photoresist layer. The exposed photoresist is developed, and the developed pattern is copied into the silicon nitride layer, e.g., by reactive ion etching. Preferential etching of the exposed portions of the silicon wafer is conveniently effected by the use of, e.g., potassium hydroxide as an etchant using a silicon nitride mask; etching may be partly into the wafer or through its entire thickness. Etch rate is typically such that a

$51 \times 10^{-3}$ cm (20-mil) wafer is etched through in a time of from 7 to 8 hours.

Etched chips are inserted into correspondingly etched grooves, wells, or openings in wafers; attachment by means of an insulating adhesive is convenient. The surface of an inserted chip is preferably essentially co-planar with the wafer surface.

A layer of a planarizing material such as, e.g., a polyimide or other photo-definable polymer, is deposited over the assembly, and holes corresponding to underlying circuit contact pads are etched by photolithographic patterning followed by reactive ion etching. A metallization such as, e.g., an aluminum metallization is applied and patterned by reactive ion etching.

Among suitable chip and wafer materials other than silicon are III—V semiconductor compounds such as, e.g., gallium arsenide and gallium arsenide indium phosphide.

Among advantages of the new insulating circuit assembly are the following:

1. The new approach eliminates wire bonding operation.

2. The new approach eliminates a level of individual packaging namely, e.g. so-called DIP or chip carriers.

3. All chips of an electronic system or subsystem are packaged in one operation.

4. Circuit design is facilitated by contacts for metallization which can be located at any place inside the chip.

5. Multilevel metallization can be made by repeated deposition of insulating layers, metallization, and patterning.

6. The length of interconnections between chips can be minimized by suitable arrangement of chips on a substrate; this will reduce parasitic inductance and resistance. Parasitic capacitance decreases with increasing thickness of an insulating layer.

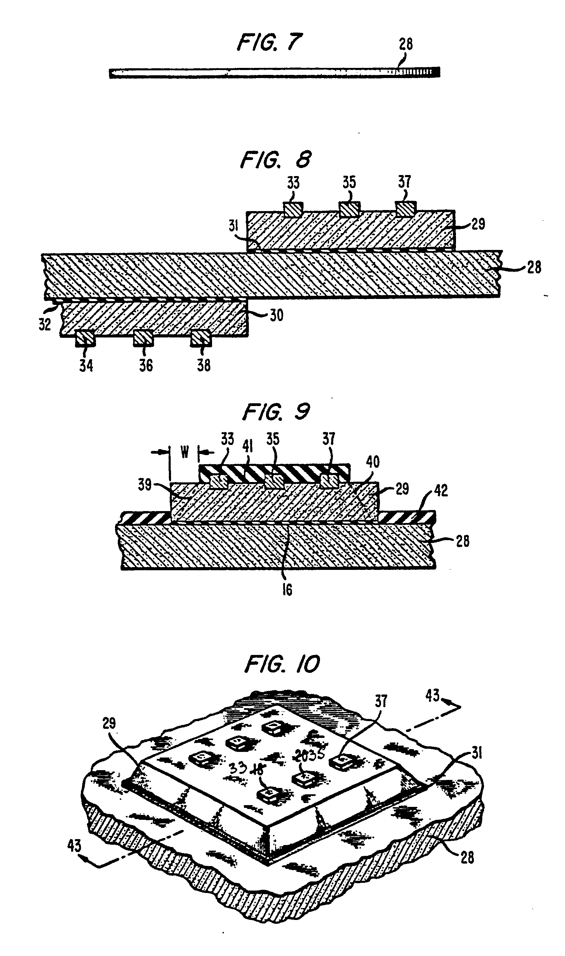

Fig. 7 shows a wafer 28 that constitutes an integral part of an assembly embodying the present invention. Advantageously, the wafer 28 comprises a disc about 75-to-150 millimeters in diameter, with a thickness $t$ of approximately 0.5 millimeters. Illustratively, the wafer 28 comprises a monocrystalline silicon wafer.

Fig. 8 shows in enlarged form a portion of the afore-described wafer 28. Additionally, Fig. 8 depicts a microminiature device, for example a silicon-integrated-circuit chip 29, adhered to the top of the wafer 28 by means of a bonding layer 31. By way of example, the layer 31 comprises an adhesive material such as a conventional polyimide material or a silicon dioxide layer. Illustratively, the layer 31 is spun on the bottom surface of the chip 29 to a thickness of about 0.1-to-10 micrometers before the chip 29 is placed in contact with the wafer 28.

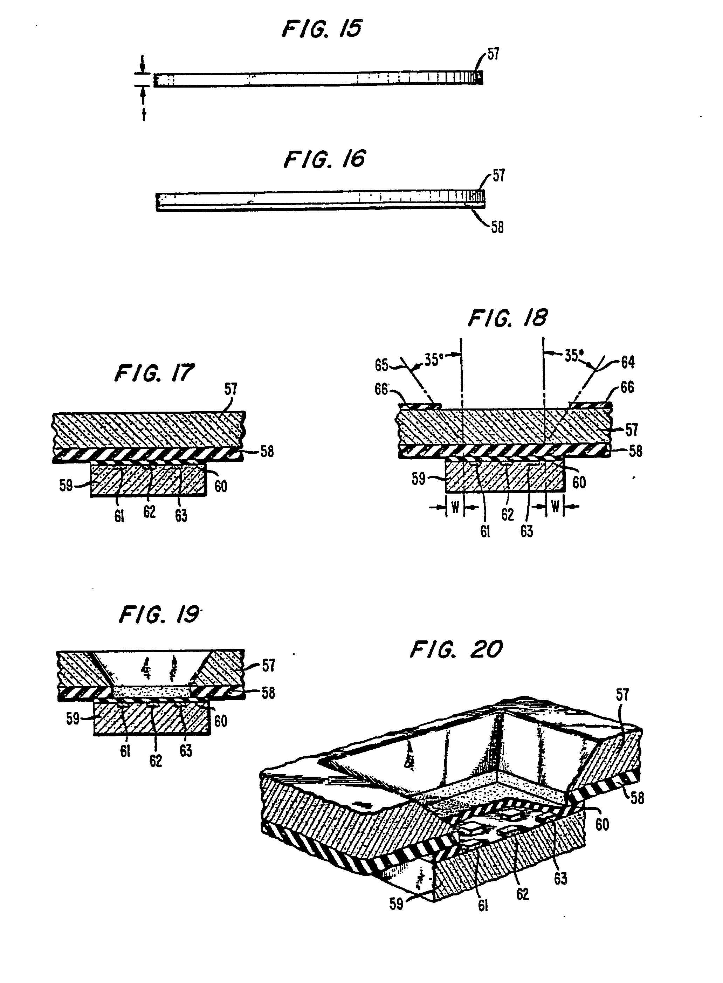

In an embodiment of the present invention, one or more microminiature devices such as the chip 29 are adhered to the top side of the wafer 28 depicted in Fig. 17. The chip 59 is, for example, about 0.25-to-0.75 millimeters thick and includes a square top surface about six millimeters on a side. In some applications of applicant's invention, as many as 100 or even more devices of various designs and types are mounted on the top side of the wafer 28.

Advantagously, the devices mounted on the wafer 28 constitute chips cut from a wafer of monocrystalline silicon whose top and bottom surfaces were parallel (100) crystalline planes of the silicon structure. Accordingly, the top and bottom surfaces of each chip mounted on the wafer 28 also lie in (100) planes. The reason for selecting this particular orientation will be evident later below when a preferential etching step included in the fabrication sequence for the assembly is described.

In performing the invention, multiple devices of various designs and types can be mounted on the bottom, as well as on the top, of the wafer 28. This is indicated in Fig. 8 wherein a device 30 is shown mounted on the bottom side of the wafer 28 by means of adhesive layer 32.

The top of the chip 29 and the bottom of the chip 30 shown in Fig. 8, respectively, constitute the so-called active sides thereof. Included on the active side of each chip are standard elements such as transistors (not shown), alignment marks (not shown), etc. Also included thereon are multiple relatively small-area conductive pads. Three such pads 33, 35, and 37 on chip 29, and three such pads 34, 36 and 38 on the chip 30, are schematically depicted in Fig. 8. Each pad has, for example, a square surface area only about 2.5-to-10 micrometers on a side.

Importantly, the small-area pads included on the chips 29 and 30 (Fig. 8) can be located anywhere within the central region of the top surface thereof. In other words, the pads are not limited to being located along the periphery of the central region. Thus, as indicated in Fig. 8, some of the pads can be located in or towards the middle of the central region. This is advantageous because it reduces the total lead length required on a chip. As a result, the losses and delays experienced by signals that are propagated from the chip to associated circuitry are reduced. Moreover, the combination of reduced lead length and small-area pads leaves more of the active area available for other elements. Consequently, denser integrated designs are thereby made feasible.

So as not to unduly clutter the drawing, emphasis hereinafter in connection with the description of Figs. 9 through 13 will be directed to a portion of an assembly in which a single device (the chip 29) is mounted on the top side of the wafer 28. It is to be understood, however, that what is said about the processing of the chip 29 is also applicable to the processing of one or more additional devices mounted on the top side of the wafer 28 and to the processing of at least one additional device (such as the chip 30 of Fig. 8) mounted on the bottom side of the wafer 28.

Sloped edges are formed on each of the devices mounted on the wafer 28. These sloped edges extend from the perimeter of the central region of each device toward the wafer side on which the device is mounted. Advantageously, these edges are formed in a particular well-defined etching step in which each chip mounted on the wafer 28 is inherently preferentially etched to reveal (111) planes that constitute the desired sloped edges. Thus, as indicated in Fig. 9 (which shows a portion of the assembly taken along lines 43 in Fig. 10) by reference lines 39 and 40, each edge to be formed on the chip 29 will be inclined at an angle of 54—55 degrees with respect to the top surface of the chip 29. In that way, a peripheral band of the top surface of the chip 29 will be removed by etching. (Of course, this band need not be continuous or closed. In fact, in some cases one sloped edge per chip may be sufficient to satsify the purposes of the invention.) In one specific illustrative embodiment, the width $w$ (Fig. 9) of this band is about 300-to-1000 micrometers.

Advantageously, the sloped-edge chip 29 whose outline is represented in Fig. 9 is formed by selectively masking the top surface of the chip 29 and then exposing the chip to a wet etchant such as a solution of potassium hydroxide. A suitable etch-resistant mask for such an etchant is made, for example, of silicon nitride. A layer 41 of silicon nitride patterend by conventional lithographic techniques is shown in Fig. 9.

Additionally, if the wafer 28 of Fig. 9 is made of silicon, or of another material that is etched by a potassium hydroxide solution, an etch-resistant layer is also formed on the top surface of the wafer prior to defining the afore-specified sloped edges on the mounted chip(s). Such an etch-resistant layer 42 made of silicon nitride is indicated in Fig. 9. Illustratively, the layers 41 and 42 are each approximately 200 nm thick.

An advantageous etchant for forming the aforedescribed sloped edges on the chip 29 (Fig. 2) comprises approximately 250 grams of potassium hydroxide dissolved in 0.8 liters of water and 0.2 liters of propanol. Etching for about 3-to-10 hours with such a solution is effective to form the desired sloped edges. Subsequently, the silicon nitride masking layers 41 and 42 can be removed by, for example, etching the structure in hot phosphoric acid, as is well known in the art. At that point in the fabrication sequence, the assembly appears as depicted in the perspective view of Fig. 10.

The afore-specified slope of the edges of the chip 29 is not critical. The sloped edges merely serve to facilitate the formation of conductive runners thereon. Preferential etching, as described above, is one convenient and advantageous way of achieving such sloped edges. But other techniques may be employed to form sloped edges on the chips.

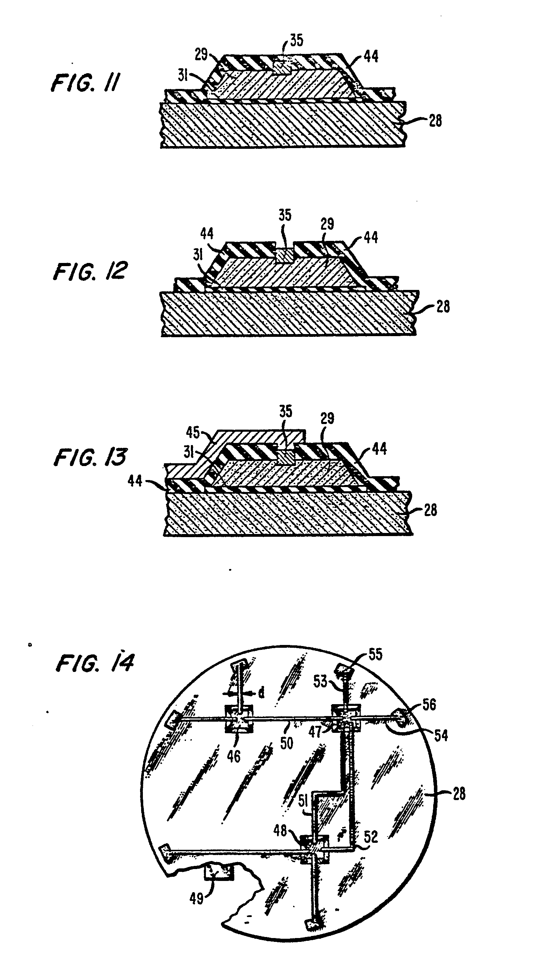

As indicated in Fig. 11, the next step in the fabrication sequence is to form an insulating layer 44 over the entire top surface of the depicted assembly. Illustratively, the layer 44 comprises a deposited layer of silicon dioxide about one micrometer thick.

So as to not unduly clutter the drawing, only one conductive pad 35 on the chip 29 is explicitly shown in Fig. 11. It should be understood, however, that as many as 1000, or even more, small-area pads may be actually included on a typical chip.

Etching of the layer 44 is then carried out in a standard fashion utilizing-conventional integrated-circuit patterning techniques to provide an opening in the layer 44 in registry with the conductive pad 35. In that way, the top surface of the conductive pad 35 is exposed, as indicated in Fig. 12.

Next, a conductive layer approximately one micrometer thick made, for example, of aluminum is deposited over the entire top surface of the assembly shown in Fig. 12. The conductive layer is then patterned by conformal lithographic techniques (utilizing, for example, a germanium selenide resist) to form fine-line runners that extend from the chip pads, down one or more of the oxide-coated sloped edges of each chip and onto the main top surface of the assembly. In turn, these runners extend to conductive pads included on other mounted chips and/or to relatively large-area pads disposed around the periphery of the chip-wafer assembly.

A single conductive runner 45 is represented in Fig. 13. The runner 45 contacts the pad 35 on the chip 29 and extends down one sloped edge of the chip 29 to overlie the silicon dioxide layer 44 that constitutes the main top surface of the depicted assembly.

Additional alternating insulating and conductive layers (not shown) may be deposited on top of the assembly represented in Fig. 13. In that way, multi-level conductive patterns may be formed in the assembly. In some embodiments, it is advantageous to form one or more of the conductive levels as large-area planar conductors. Such planar conductors may be utilized, for example, as low-resistance low-inductance ground and/or power plane.

Fig. 14 is a top schematic view of a portion of an assembly embodying the present invention. (A suitable standard encapsulant for the assembly may be advantageous but is not shown in Fig. 14.) For representative purposes only, four chips are indicated as being included in the depicted assembly. Three chips 46, 47 and 48 are shown mounted overlying the top of the wafer 28 and one chip 49 is represented as being mounted on the bottom of the wafer 28. (In a 150-millimeter wafer, it is feasible to include as many as 1000 mounted chips on the top and bottom of the wafer.) In practice, each such chip typically has multiple (for example, 100 or more) leads extending therefrom. So as not to unduly clutter Fig. 14, however, each top-mounted chip is shown in this simplified depiction as including at least three but not more than five leads.

Thus, for example, mounted chip 47 in Fig. 14 is represented as having five leads connected thereto. Lead 50 of the chip 47 extends to adjacent chip 46. Leads 51 and 52 interconnect the chips 47 and 48. Additionally, leads 53 and 54, respectively, extend between the chip 47 and peripheral conductive pads 55 and 56.

In one specific illustrative embdoiment of applicant's invention, each of the interconnecting leads shown in Fig. 14 has a width $d$ of approximately 1-to-10 micrometers. By way of example, each of the peripheral pads shown therein is about 1.25-by-1.25 millimeters. By a variety of conventional techniques, it is relatively easy matter to establish electrical connections between such large-area peripheral pads and similar assemblies and/or other components included in an overall electronic system.

It is to be understood that the above-described structures and processing techniques are only illustrative of the present invention.

Numerous modifications and alternatives may be devised by those skilled in the art.

For example, it is feasible to selectively interconnect device pads and/or peripheral pads on the top and bottom of the wafer by forming conductors that extend through via holes in the wafer. Moreover, it is feasible to fabricate composite chip-wafer assemblies that embody the concepts described herein. In such a composite assembly, sloped-wall chips and straight-wall chips would be mounted on both sides of a wafer that contains sloped-wall through apertures.

Also, it is to be understood that the wafer 28 may be made of a material other than silicon. In selecting an alternative material, factors such as matching the thermal properties of the wafer to those of the associated chips are to be considered.

Fig. 15 shows a wafer 57 that constitutes an integral part of an assembly embodying the present invention. Advantageously, the wafer 57 is made of monocrystalline silicon and is cut in the form of a disc about 75-to-150 millimeters in diameter, with a thickness $t$ of approximately 0.5 millimeters. In accordance with an advantageous feature of this invention, the top and bottom surfaces of the wafer 57 are parallel and lie in (100) crystalline planes of the silicon structure. The reason for selecting this particular orientation will be evident later below when a preferential etching step included in the fabrication sequence for the assembly is described.

Illustratively, an etch-resistant layer 58 shown in Fig. 16 is deposited on the entire bottom surface of the wafer 57. By way of example, the layer 58 comprises silicon nitride deposited to a thickness of approximately 100 nm.

Fig. 17 shows in enlarged form a portion of the afore-described wafer 10 and layer 58. Additionally, Fig. 17 depicts a microminiature device, for example, a silicon-integrated-circuit chip 59, adhered to the bottom of the layer 58 by means of a bonding layer 60. By way of example, the layer 60 comprises an adhesive material such as a conventional layer of silicon dioxide or a standard polyimide material. Illustratively, the layer 60 is spun on the top surface of the chip 59 to a thickness of about 0.1-to-10 micrometers before the chip 59 is placed in contact with the layer 58.

One or more microminiature devices such as the chip 59 are adhered to the underside of the wafer 57 depicted in Fig. 3. The chip 29 is, for example, about 0.25-to-0.75 millimeters thick and includes a square top surface about six millimeters on a side. In some applications of applicant's invention, as many as 100 or even more devices of various designs and types are mounted on the underside of the wafer 57.

The top of the chip 59 shown in Fig. 17 constitutes the so-called active side thereof. Included on the active side of the chip are standard elements such as transistors (not shown), alignment marks (not shown), etc. Also included thereon are multiple relatively small-area conductive pads. Three such pads 61, 62 and 63 located in a central region of the active side of the chip are schematically depicted in Fig. 17. Each pad has, for example, a square top surface area only about 2.5-to-10 micrometers on a side.

Importantly, the small-area pads included on the chip 59 can be located anywhere within the central region of the top surface. In other words, the pads are not limited to being located along the periphery of the central region. Thus, as indicated in Fig. 17, some of the pads can be located in or towards the middle of the central region. This is advantageous because it reduces the total lead length required on the chip. As a result, the losses and delays experienced by signals that are propagated from the chip to associated circuitry are reduced. Moreover, the combination of reduced lead length and small-area pads leaves more of the active area available for other elements. Consequently, denser integrated circuit designs are thereby made feasible.

A well-defined through-aperture with four sloped walls is formed in the wafer in registry with the central region of each mounted device such as the chip 59.

Advantageously, the apertures are formed in a particular wet etching step in which the wafer 57 is inherently preferentially etched to reveal (111) planes that constitute the desired sloped walls. Thus, as indicated in Fig. 18 by reference lines 64 and 65, each wall to be formed in the wafer 57 will be inclined at an angle of 35—36 degrees with respect to vertical walls through the wafer.

The bottom or smaller opening of each sloped-wall through-aperture in the wafer 57 is designed to overlie only the central region of an associated chip. In that way, a peripheral band of the chip that does not include conductive pads remains adhered to the underside of the wafer. In specific embodiments, the width $w$ (Fig. 18) of this band is, for example, about 10-to-250 micrometers. Of course, this band need not be continuous or closed or uniform in width.

Advantageously, the through-aperture whose outline is represnted in Fig. 18 is formed by selectively masking the top surface of the wafer 57 and then exposing the wafer to a wet etchant such as a solution of potassium hydroxide. A suitable etch-resistant mask for such an etchant is made, for example, of silicon nitride. A layer 66 of silicon nitride patterned by conventional lithographic techniques is shown in Fig. 18. Illustratively, the layer 66 is approximately 200 nm thick.

An advantageous etchant for forming the aforedescribed through-aperture in the wafer 57 comprises approximately 250 grams of potassium hydroxide dissolved in 0.8 liters of water and 0.2 liters of propanol. Etching for about 3-to-10 hours with such a solution is effective to form the desired sloped-wall aperture(s) in the herein-specified wafer 57. Subsequently, the top silicon nitride masking layer 66 and that portion of the bottom silicon nitride layer 58 directly underlying the smaller opening of the aperture can be removed by, for example, etching the structure in hot phosphoric acid, as is well known in the art.

At that point in the fabrication sequence, the assembly appears as depicted in Figs. 19 and 20. In the perspective view of Fig. 20, the adhesive layer 60 is partially broken away to show some of the small-area conductive pads included on the chip 59. These include the previously specified pads 61, 62 and 63.

The entire exposed portion of the adhesive layer 60 shown in Fig. 20 may be removed by utilizing a standard etchant therefor. Alternatively, it may be advantageous to leave the layer 60 substantially intact and to subsequently etch only small-area openings therethrough in registry with associated underlying conductive pads on the chip 59. In the further fabrication steps described below, this latter alternative approach will be specified.

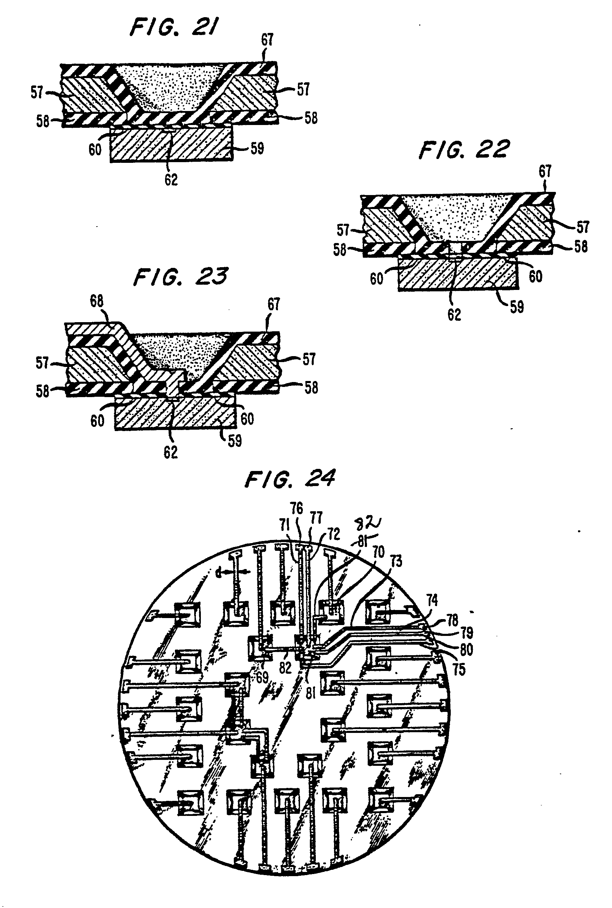

As indicated in Fig. 21, the next step is to form an insulating layer 67 over the entire top surface of the depicted assembly. Illustratively, the layer 67 comprises a deposited layer of silicon dioxide about one micrometer thick.

So as to not unduly clutter the drawing, only one conductive pad 62 on the chip 59 is explicitly shown in Fig. 21. It should be understood, however, that in some applications of the invention as many as 1000, or even more, small-area pads may be actually included on some chips.

Etching of the layer 67 is then carried out in a standard fashion utilizing conventional integrated-circuit patterning techniques to provide an opening in the layer 67 in registry with the conductive pad 62. Either in the same step in which the layer 67 is etched or in a subsequent etching step, a corresponding opening is also formed in the adhesive layer 60. In that way, the top surface of the conductive pad 62 is exposed, as indicated in Fig. 22.

Next, a conductive layer approximately one micrometer thick made, for example, of aluminum is deposited over the entire top surface of the assembly shown in Fig. 22. The conductive layer is then patterned by conformal lithographic techniques (utilizing, for example, a germanium selenide resist) to form fine-line runners that extend from the chip pads, up one or more of the sloping walls of the aperture associated with each chip and onto the main top surface of the assembly. In turn, these runners extend to other mounted chips and/or to relatively large-area pads disposed around the periphery of the chip-wafer assembly.

A single conductive runner 68 is represented in Fig. 23. The runner 68 contacts the pad 62 on the chip 59 and extends up one sloped wall of the depicted aperture to overlie the silicon dioxide layer 67 that constitutes the main top surface of the depicted assembly.

Additional alternating insulating and conductive layers (not shown) may be deposited on top of the assembly represented in Fig. 23. In that way, multi-level conductive patterns may be formed in the assembly. In some embodiments, it is advantageous to form one or more of the conductive levels as large-area planar conductors. Such planar conductors may be utilized, for example, as low-resistance low-inductance ground and/or power planes.

Fig. 24 is a top schematic view of a portion of an assembly embodying the present invention. (A suitable standard encapsulant for the assembly may be advantageous but is not shown in Fig. 24.) For representative purposes only, twenty-four chips are indicated as being included in the depicted assembly. (In a 150-millimeter wafer, it is feasible to include as many as 500 mounted chips.) In practice, each such chip typically has multiple (for example, 100 or more) leads extending therefrom. So as not to unduly clutter Fig. 24, however, each mounted chip is shown in this simplified depiction as including at least one but not more than seven leads.

Thus, for example, mounted chip 81 in Fig. 24 is represented as having seven leads connected thereto. Leads 82 and 83 of the chip 81, respectively, extend to adjacent chips 69 and 70. Additionally, leads 71 through 75, respectively, extend between the chip 81 and peripheral conductive pads 76 through 80.

In one specific illustrative embodiment of applicant's invention, each of the interconnecting leads shown in Fig. 24 has a width $d$ of approximately 1-to-10 micrometers. By way of example, each of the peripheral pads shown therein as about 1.25-by-1.25 millimeters. By a variety of conventional techniques, it is a relatively easy matter to establish electrical connections between such large-area peripheral pads and similar assemblies and/or other components included in an overall electronic system.

It is to be understood that the above-described structures and processing techniques are only illustrative of the present invention.

Numerous modifications and alternatives may be devised by those skilled in the art.

For example, it is feasible to fabricate composite chip-wafer assemblies that embody the concepts described herein. In such a composite assembly, sloped-wall chips and straight-wall chips would be mounted on both sides of a wafer that contains sloped-wall through apertures.

Also, it is to be understood that the wafer 57 may in some cases of practical importance be made of a material other than silicon. In selecting an alterative material, factors such as matching the thermal properties of the wafer to those of the associated chips and the amenability of the wafer to being preferentially etched are to be considered. But, of course, it is to be realized that techniques other than etching may be employed to form the afore-specified through-apertures. The slope of the walls of these apertures is not critical. The sloped walls merely serve to facilitate the formation of runners thereon. Preferential etching, as described above, is one convenient and advantageous way of achieving such sloped-wall apertures.

## Claims

1. A device comprising a substrate and at least one integrated circuit chip attached to said substrate, said substrate consisting essentially of a single-crystal material, and said at least one integrated circuit chip being electrically connected to lithographically defined electrical circuitry on said substrate, characterized in that said substrate has at least one surface depression (hereinafter referred to as "well") which has at least one sloping wall resulting from crystallographically anisotropic etching, said at least one chip has at least one beveled edge resulting from crystallographically anisotropic etching, and said at least one beveled edge and said at least one sloping wall are in juxtaposition and being mutually supplementary, whereby said at least one chip is positioned on said substrate.

2. A device according to claim 1, wherein said at least one chip has a circuit-carrying side which faces into said at least one well.

3. A device according to claim 2, wherein contact is made to said circuit by at least one stripe conductor as a sidewall of said wall.

4. A device according to any one of claims 1 to 3, comprising a plurality of chips, said chips being electrically interconnected by electrical conductors on said substrate.

5. A device according to claim 4, wherein said electrical conductors are separated by a photodefinable polymer material.

6. A device according to any one of claims 1 to 5, comprising at least one passive component which is mounted on said at least one chip.

7. A device according to any one of claims 1 to 6, wherein at least one optical fiber terminates on said at least one chip.

8. A device according to any one of claims 1 to 7, wherein said substrate is a wafer, the material of said at least one chip being in essentially the same single-crystal form at the material of said wafer, said at least one chip has a first surface and at least one first sidewall forming a first angle with said first surface, said angle being less than 90 degrees as resulting from etching of the material of said at least one chip, said wafer has a second surface and at least one second sidewall forming a second angle with said second surface, said second angle being essentially supplementary to said first angle as resulting from etching of the material of said wafer, said at least one chip is in alignment with respect to said wafer as a result of matching between said at least one first sidewall and said at least one second sidewall, said at least one chip carries an integrated circuit, and a planarizing layer overlying said circuit and at least a portion of said wafer, and electrical connection to said circuit is made by metallization which overlies said planarizing layer.

9. A device comprising a substrate and at least one integrated circuit chip attached to said substrate, said substrate consisting essentially of a single-crystal material, and said at least one circuit chip being electrically connected to lithographically defined electrical circuitry on said substrate, characterised in that said substrate is a wafer having top and bottom surfaces, the wafer having conductive terminal portions along the periphery thereof overlying said top and bottom surfaces, at least one of said circuit chips is mounted on one of said surfaces of the wafer and includes conductive elements in a central portion of the chip, and a conductive pattern connects the elements of the mounted chip to selected ones of said terminal portions or to elements included on at least one other mounted chip, and wherein (a) whenever said conductive elements are on an unmounted surface of the chip, each chip has at least one sloped edge extending from said central portion of the chip toward the surface of the wafer carrying the mounted chip, said pattern being disposed on sloped edge(s) of each mounted chip and overlying the surface of the wafer, and (b) whenever said conductive elements are on a mounted surface of the chip, said wafer has an opening exposing the central portion of the chip with at least one wall of the opening sloping away from the chip and toward the surface of the wafer opposite to that carrying the chip, said pattern being disposed on said at least one of the sloped walls of the wafer associated with the mounted chip and overlying the said opposite surface of the wafer..

10. A device according to claim 9, wherein at least one of said chips is mounted on the top surface of the wafer or on the bottom surface of the wafer or on both, the top and bottom surfaces of the wafer.

11. A device according to claim 9 or 10, wherein said at least one chip comprises a monocrystalline silicon chip the top and bottom surfaces of which lie in (100) crystalline planes.

12. A device according to claim 11, wherein said at least one sloped edge lies in a (111) crystalline plane of said silicon chip.

13. A device according to any one of claims 9 to 12, wherein the instrumentality mounting each chip on said wafer comprises an adhesive layer interposed between each device and said wafer.

14. A device according to any one of claims 9 to 13, comprising a plurality of semiconductor chips each having front and back surfaces with its back surface contacting the surface of said substrate and its front surface including a plurality of conductive pads which provide external connections to circuit elements within the chip, each chip having at least one sloping edge extending from its front surface to said substrate, and conductive paths extending from the conductor pads along the sloping edges of the chips and the surface of the substrate for interconnecting chips to one another and to the terminal pads on the susbtrate.

15. A device according to claim 9, comprising a plurality of semiconductor chips, each having a plurality of conductive pads on a top surface for providing electrical connections to circuit elements in the chip, a cap member to one surface of which is bonded separately at least a portion of the top surface of each of the plurality of chips, the cap member including sloped-wall apertures to permit access to the conductive pads, and conductive paths overlying an opposite surface of the cap member and extending along the sloped sidewalls of the apertures for contacting the conductive pads and interconnecting the chips.

16. A device according to any one of claims 9 to 15, wherein the instrumentality mounting each chip on the respective surface of said wafer comprises an adhesive layer.

17. A device according to any one of claims 9 to 16, wherein said at least one chip carries an integrated circuit, and a planarizing layer overlying said circuit and at least a portion of said wafer, and electrical connection to said circuit is made by metallization which overlies said planarizing layer.

18. A device according to claim 8 or 17, comprising two or more planarizing layers and metallizations.

19. A device according to claim 8, 17 or 18, wherein the material of the or each planarizing layer is a photodefinable material.

20. A device according to any one preceding claim, wherein the material of at least a body portion of said substrate and the material of at least a body portion of said at least one chip have the same crystallographic structure.

21. A device according to claim 20, wherein the material of said body portion of said substrate is essentially the same as the material of said body portion of said at least one chip.

22. A device according to any one preceding claim, wherein said material is a semiconductor material.

23. A device according to any one preceding claim, wherein said material is essentially silicon.

24. A device according to any one preceding claim, wherein said electrical circuitry comprises a ground conductor and a power conductor, and a decoupling capacitor between said ground conductor and said power conductor.

25. A device according to claim 24, wherein said decoupling capacitor is a metal-oxide-semiconductor capacitor.

26. A device according to claim 25, wherein said capacitor consists of said substrate, an oxide layer on said substrate, and a metallic layer on said oxide layer.

**Patentansprüche**

1. Vorrichtung mit einem Substrat und wenigstens einem hieran befestigten integrierten Schaltungschip, wobei das Substrat in wesentlichen aus einkristallinem Material besteht und das integrierte Schaltungschip mit der auf dem Substrat lithographisch definierten elektrischen Schaltungsanordnung elektrisch verbunden ist, dadurch gekennzeichnet, daß

das Substrat wenigstens eine Oberflächenvertiefung (nachstehend als "Wanne" bezeichnet) aufweist, die wenigstens eine von kristallographisch anisotroper Ätzung herrührende Schrägwand besitzt,

das Chip wenigstens eine von kristallographisch anisotroper Ätzung herrührende abgeschrägte Kante besitzt und

die abgeschrägte Kante und die Schrägwand zueinander benachbart liegen und sich gegenseitig ergänzen, wodurch das Chip auf dem Substrat positioniert ist.

2. Vorrichtung nach Anspruch 1, bei der das Chip eine schaltungstragende Seite besitzt, die in die Wanne eingefügt ist.

3. Vorrichtung nach Anspruch 2, bei der Kontakt zu der Schaltung hergestellt ist durch wenigstens einen Streifenleiter auf einer Seitenwand der Wanne.

4. Vorrichtung nach einem der Ansprüche 1 bis 3, umfassend eine Vielzahl von Chips, die elektrisch über elektrische Leiter auf dem Substrat miteinander verbunden sind.

5. Vorrichtung nach Anspruch 4, bei der die elektrischen Leiter durch ein photodefinierbares Polymerisatmaterial voneinander getrennt sind.

6. Vorrichtung nach einem der Ansprüche 1 bis 5, umfassend wenigstens eine passive Komponente, die auf dem Chip montiert ist.

7. Vorrichtung nach einem der Ansprüche 1 bis 6, bei der wenigstens eine optische Faser auf dem Chip endigt.

8. Vorrichtung nach einem der Ansprüche 1 bis 7, bei der das Substrat ein Wafer ist, das Material des Chips im wesentlichen dieselbe einkristalline Form wie das Material das Wafers hat, das Chip eine erste Fläche und wenigstens eine erste Seitenwand besitzt, die einen ersten Winkel mit der ersten Fläche bildet, der Winkel weniger als 90° als Folge einer Ätzung des Chipmaterials beträgt, das Wafer eine zweite Fläche und wenigstens eine zweite Seitenwand besitzt, die einen zweiten Winkel mit der zweiten Fläche bildet, der zweite Winkel im wesentlichen die Ergänzung zu dem ersten Winkel als das Resultat einer Ätzung des Wafermaterials ist, der Chip gegenüber dem Wafer als Ergebnis einer Anpassung zwischen der ersten und der zweiten Seitenwand ausgerichtet ist,

der Chip eine integrierte Schaltung und eine einebnende Schicht, die über der Schaltung und wenigstens einem Teil des Wafers liegt, trägt und

eine elektrische Verbindung mit der Schaltung durch eine Metallisierung, die über der einebnenden Schicht liegt, erfolgt.

9. Vorrichtung mit einem Substrat und wenigstens einem hieran befestigten integrierten Schaltungschip, wobei das Substrat im wesentlichen aus ein Kristallinem Material besteht und das integrierte Schaltungschip mit der auf dem Substrat lithographisch definierten elektrischen Schaltungsanordnung elektrisch verbunden ist, dadurch gekennzeichnet, daß

das Substrat ein Wafer mit oberen und unteren Flächen ist,

das Wafer leitende Anschlußteile längs seines Umfangs besitzt, die über dem oberen und unteren Flächen liegen,

wenigstens einer der Schaltungschips auf einer der Flächen des Wafers befestigt ist und leitende Elemente in einem zentralen Teil des Chips aufweist und

ein leitendes Muster die Elemente des befestigten Chips mit ausgewählten Anschlußteilen oder mit Elementen verbindet, die auf wenigstens einem weiteren befestigten Chip vorhanden sind, wobei

(a), wenn immer die leitenden Elemente auf einer unbefestigten Fläche des Chips liegen, jedes Chip wenigstens eine abgeschrägte Kante besitzt, die sich von dem zentralen Teil des Chips zur das befestigte Chip tragenden Fläche des Wafers hin erstrecken, wobei das Muster auf einer abgeschrägten Kante oder auf abgeschrägten Kanten jedes befestigten Chips angeordnet ist und über der Fläche des Wafers liegt, und

(b), wenn immer die leitenden Elemente auf einer befestigten Fläche des Chips liegen, das Wafer eine Öffnung aufweist, die den zentralen Teil des Chips freilegt, wobei wenigstens eine Wand der Öffnung vom Chip weg und in Richtung zur Fläche des Wafers abgeschrägt ist, die der das Chip tragenden Fläche entgegengesetzt ist, wobei das Muster auf wenigstens einer der abgeschrägten Wände des Wafers, die dem befestigten Chip zugeordnet sind, angeordnet ist und über der entgegengesetzten Fläche des Wafers liegen.

10. Vorrichtung nach Anspruch 9, bei der wenigstens eines der Chips auf der oberen Fläche des Wafers oder auf der unteren Fläche des Wafers oder auf beiden dieser Flächen befestigt ist.

11. Vorrichtung nach Anspruch 9 oder 10, bei der

das Chip ein einkristallines Siliciumchip umfaßt, dessen obere und untere Flächen in (100)-Kristallebenen liegen.

12. Vorrichtung nach Anspruch 11, bei der die abgeschrägte Kante in einer (111)-Kristallebene des Siliciumchips liegt.

13. Vorrichtung nach einem der Ansprüche 9 bis 12, bie der

das Befestigungsinstrumentarium für jedes Chip auf dem Wafer eine Klebschicht umfaßt, die zwischen jeder Vorrichtung und dem Wafer liegt.

14. Vorrichtung nach einem der Ansprüche 9 bis 13, umfassend

eine Vielzahl Halbleiterchips, die je vordere und hintere Flächen besitzen, wobei deren hintere Fläche die Fläche des Substrates kontaktiert und deren vordere Fläche eine Vielzahl leitender Flekken aufweist, die äußere Anschlüsse zu Schaltungselementen innerhalb des Chips bilden, wobei jedes Chips wenigstens eine abgeschrägte Kante besitzt, die sich von seiner vorderen Fläche zum Substrat erstreckt, und wobei sich leitende Wege von den Leiterflecken längs den abgeschrägten Kanten der Chips und der Fläche des Substrates erstrecken, um die Chips miteinander und mit den Anschlußflecken auf dem Substrat zu verbinden.

15. Vorrichtung nach Anspruch 9, umfassend

eine Vielzahl Halbleiterchips, von denen jedes eine Vielzahl leitender Flecken auf einer oberen Fläche besitzt, um für elektrische Verbindungen zu Schaltungselementen in dem Chip zu sorgen,

ein Abdeckglied, an dessen einer Fläche wenigstens ein Teil der oberen Fläche jedes einzelnen der Chips separat gebondet ist, wobei das Abdeckglied schrägwandige Öffnungen aufweist, um einen Zugriff zu den leitenden Flecken zu erlauben, und

leitende Wege, die über einer entgegengesetzten Fläche des Abdeckgliedes liegen und sich längs der abgeschrägten Seitenwände der Öffnungen zur Kontaktierung der leitenden Flecken und zur Verbindung der Chips untereinander erstrecken.

16. Vorrichtung nach einem der Ansprüche 9 bis 15, bei der

das Befestigungsinstrumentarium für jedes Chip auf der entsprechenden Fläche des Wafers eine Klebschicht umfaßt.

17. Vorrichtung nach einem der Ansprüche 9 bis 16, bei der

das Chip eine integrierte Schaltung und eine einebnende Schicht trägt, die über der Schaltung und wenigstens einem Teil des Wafers liegt, und

elektrische Verbindung zu der Schaltung hergestellt ist durch eine Metallisierung, die über der einebnenden Schicht liegt.

18. Vorrichtung nach Anspruch 8 oder 17, umfassend

zwei oder mehr einebnende Schichten und Metallisierungen.

19. Vorrichtung nach Anspruch 8, 17 oder 18, bei der

das Material der oder einer jeden einebnenden Schicht ein photodefinierbares Material ist.

20. Vorrichtung nach einem der vorstehenden Ansprüche, bei der

das Material wenigstens eines Körperteils des Substrates und das Material wenigstens eines Körperteils des Chips die selbe Kristallstruktur haben.

21. Vorrichtung nach Anspruch 20, bei der

das Material des Körperteils des Substrats im wesentlichen das gleiche ist wie das Material des Körperteils des Chips.

22. Vorrichtung nach einem der vorstehenden Ansprüche, bei der

das Material ein Halbleitermaterial ist.

23. Vorrichtung nach einem der vorstehenden Ansprüche, bei der

das Material im wesentlichen Silicium ist.

24. Vorrichtung nach einem der vorstehenden Ansprüche, bei der

die elektrische Schaltungsanordnung einen Erdungsleiter und einen Speiseleiter sowie einen Entkopplungskondensator zwischen den beiden Leitern umfaßt.

25. Vorrichtung nach Anspruch 24, bei der

der Entkopplungskondensator ein Metall-Oxid-Halbleiter-Kondensator ist.

26. Vorrichtung nach Anspruch 25, bei der

der Kondensator aus dem Substrat, einer Oxidschicht auf dem Substrat und einer metallischen Schicht auf der Oxidschicht besteht.

**Revendications**

1. Un dispositif comprenant un substrat et au moins une puce de circuit intégré fixée sur ce substrat, le substrat consistant essentiellement en un matériau monocristallin, et la ou les puces de circuits intégrés étant connectées électriquement à des circuits électriques définis par lithographie sur le substrat, caractérisé en ce que le substrat comporte au moins une dépression de surface (qu'on appelle ci-après un "puits") qui présente au moins une paroi en pente, résultant d'une attaque anisotrope au point de vue cristallographique, la ou les puces comportant au moins un bord biseauté qui résulte d'une attaque anisotrope au point de vue cristallographique, et ce ou ces bords biseautés et la ou les parois en pente sont juxtaposés et mutuellement supplémentaires, grâce à quoi la ou les puces sont positionnées sur le substrat.

2. Un dispositif selon la revendication 1, dans lequel la ou les puces présentent une face de support de circuit qui se trouve du côté de l'intérieur du ou des puits.

3. Un dispositif selon la revendication 2, dans lequel un contact est établi avec le circuit au moyen d'au moins un conducteur en bande sur une paroi latérale du puits.

4. Un dispositif selon l'une quelconque des revendications 1 à 3, comprenant un ensemble de puces, et ces puces sont électriquement interconnectées par des conducteurs électriques formés sur le substrat.

5. Un dispositif selon la revendication 4, dans lequel les conducteurs électriques sont séparés par un matériau polymère dont la configuration peut être définie par des moyens optiques.

6. Un dispositif selon l'une quelconque des revendications 1 à 5, comprenant au moins un composant passif qui est monté sur la ou les puces.

7. Un dispositif selon l'une quelconque des revendications 1 à 6, dans lequel au moins une fibre optique aboutit à au moins une puce.

8. Un dispositif selon l'une quelconque des revendications 1 à 7, dans lequel le substrat est une tranche, le matériau de la puce ou des puces est pratiquement sous la même forme monocristalline que le matériau de la tranche, la ou les puces comportent une première surface et au moins une première paroi latérale formant un angle avec cette première surface, l'attaque du matériau de la puce ou des puces donnant à cet angle une valeur inférieure à 90°, la tranche comporte une seconde surface et au moins une seconde paroi latérale formant un second angle avec la seconde surface, l'attaque du matériau de la tranche donnant à ce second angle une valeur pratiquement supplémentaire de celle de premier angle, la ou les puces sont alignées par rapport à la tranche du fait de l'adaptation entre la ou les premières parois latérales et la ou les secondes parois latérales, la ou les puces portent un circuit intégré, et une couche d'aplanissement recouvrant le circuit et au moins une partie de la tranche, et une connexion électrique avec ce circuit est établie par une métallisation qui s'étend sur la couche d'aplanissement.

9. Un dispositif comprenant un substrat et au moins une puce de circuit intégré fixée sur ce substrat, le substrat consistant essentiellement en un matériau monocristallin, et la ou les puces de circuits étant connectées électriquement à un circuit électrique qui est défini par lithographie sur le substrat, caractérisé en ce que le substrat est une tranche ayant des surfaces supérieure et inférieure, la tranche comportant des parties de bornes conductrices disposées à sa périphérie, qui s'étendent sur les surfaces supérieure et inférieure, l'une au moins des puces de circuits est montée sur l'une des surfaces précitées de la tranche et comprend des éléments conducteurs dans une partie centrale de la puce, et un motif conducteur connecte les éléments de la puce montée sur la tranche à certaines sélectionnées des parties de bornes ou à des éléments qui sont incorporés dans au moins une autre puce montée, et dans lequel (a) chaque fois que les éléments conducteurs précités se trouvent sur une surface de la puce qui n'est pas une surface de montage, chaque puce comporte au moins un bord en pente qui s'étend à partir de la partie centrale de la puce en direction de la surface de la tranche portant la puce montée, le motif précité étant disposé sur le ou les bords en pente de chaque puce montée et s'étendant sur la surface de la tranche, et (b) chaque fois que les éléments conducteurs se trouvent sur une surface de la puce qui est une surface de montage, la tranche comporte une ouverture qui met à nu la partie centrale de la puce, avec au moins une paroi de l'ouverture en pente dans une direction allant de la surface de la puce vers la surface de la tranche qui est opposée à celle qui porte la puce, le motif précité étant disposé sur la ou les parois en pente de la tranche qui sont associées à la puce montée, et ce motif s'étendant sur la surface opposée précitée de la tranche.

10. Un dispositif selon la revendication 9, dans lequel l'une au moins des puces est montée sur la surface supérieure de la tranche ou sur la surface inférieure de la tranche, ou bien des puces sont montées à la fois sur les surfaces supérieure et inférieure de la tranche.

11. Un dispositif selon la revendication 9 ou 10, dans lequel la ou les puces consistent en une puce de silicium monocristallin dont les surfaces supérieure et inférieure s'étendant dans des plans cristallographiques (100).

12. Un dispositif selon la revendication 11, dans lequel le ou les bords en pente s'étendent dans un plan cristallographique (111) de la puce en silicium.

13. Un dispositif selon l'une quelconque des revendications 9 à 12, dans lequel les moyens qu'on utilise pour le montage de chaque puce sur la tranche comprennent une couche adhésive qui est intercalée entre chaque dispositif et la tranche.

14. Un dispositif selon l'une quelconque des revendications 9 à 13, comprenant un ensemble de puces de semiconducteurs ayant chacune des surfaces avant et arrière, avec la surface arrière de chaque puce en contact avec la surface du substrat, et sa surface avant comprenant un ensemble de plots conducteurs qui établissent des connexions externes vers des éléments de circuit qui sont incorporés dans la puce, chaque puce comprenant au moins un bord en pente qui s'étend à partir de sa surface avant, en direction du subtrat, et des chemins conducteurs qui s'étendent à partir des plots conducteurs, le long des bords en pente des puces et de la surface du substrat, pour interconnecter des puces les unes aux autres et aux plots de bornes sur le substrat.

15. Un dispositif selon la revendication 9, comprenant un ensemble de puces dé semiconducteurs, ayant chacune un ensemble de plots conducteurs sur une surface supérieure, pour établir des connexions électriques avec des éléments de circuit dans la puce, un élément de recouvrement à une surface duquel est fixée séparément au moins une partie de la surface supérieure de chaque puce de l'ensemble de puces, l'élément de recouvrement comprenant des trous à parois en pente, pour permettre l'accès aux plots conducteurs, et des chemins conducteurs qui s'étendent sur une surface opposée de l'élément de recouvrement et qui s'étendent le long des parois latérales en pente des trous, pour venir en contact avec les plots conducteurs et pour interconnecter les puces.

16. Un dispositif selon l'une quelconque des revendications 9 à 15, dans lequel les moyens qu'on utilise pour monter chaque puce sur la surface respective de la tranche comprennent une couche adhésive.

17. Un dispositif selon l'une quelconque des revendications 9 à 16, dans lequel la ou les puces portent un circuit intégré, et une couche d'aplanissement qui recouvre ce circuit et au moins une partie de la tranche, et une connexion électrique avec ce circuit est établie par une métallisation qui s'étend sur la couche d'aplanissement.

18. Un dispositif selon la revendication 8 ou 17, comprenant au moins deux couches d'aplanissement et au moins deux métallisations.

19. Un dispositif selon la revendication 8, 17 ou 18, dans lequel le matériau de la couche ou de chaque couche d'aplanissement est un matériau dont on peut définir la configuration par des moyens optiques.

20. Un dispositif selon l'une quelconque des revendications précédentes, dans lequel le matériau d'au moins une partie principale du substrat et le matériau d'au moins une partie principale d'au moins une puce ont la même structure cristallographique.

21. Un dispositif selon la revendication 20, dans lequel le matériau de la partie principale du substrat est pratiquement le même que le matériau de la partie principale d'au moins une puce.

22. Un dispositif selon l'une quelconque des revendications précédentes, dans lequel le matériau précité est un matériau semiconducteur.

23. Un dispositif selon l'une quelconque des revendications précédentes, dans lequel le matériau précité consiste essentiellement en silicium.

24. Un dispositif selon l'une quelconque des revendications précédentes, dans lequel le circuit électrique comprend un conducteur de masse et un conducteur d'alimentation, ainsi qu'un condensateur de découplage entre le conducteur de masse et le conducteur d'alimentation.

25. Un dispositif selon la revendication 24, dans lequel le condensateur de découplage est un condensateur métal-oxyde-semiconducteur.

26. Un dispositif selon la revendication 25, dans lequel le condensateur précité est constitué par le substrat, une couche d'oxyde sur le substrat et une couche métallique sur la couche d'oxyde.

EP 0 154 431 B1

FIG. 1

FIG. 2

FIG. 3

## FIG. 4

## FIG. 5

## FIG. 6

FIG. 7

FIG. 8

FIG. 9

FIG. 10

FIG. 11

FIG. 12

FIG. 13

FIG. 14

FIG. 15

57

FIG. 16

57

58

FIG. 17

57

58

59          60

61    62    63

FIG. 18

65    35°        35°    64

66                        66

57

58

59                    60

W                W

61    62    63

FIG. 19

57

58

59              60

61    62    63

FIG. 20

57

58

60

63

62

61

59

## FIG. 21

## FIG. 22

## FIG. 23

## FIG. 24